Europäisches Patentamt

European Patent Office

Office européen des brevets

(11) Publication number: **0 367 081 A2**

# EUROPEAN PATENT APPLICATION

(21) Application number: **89119792.3**

(22) Date of filing: **25.10.89**

(51) Int. Cl.⁵: **B23K 20/00 , H01L 21/603**

(30) Priority: **31.10.88 US 264639**

(43) Date of publication of application:
**09.05.90 Bulletin 90/19**

(84) Designated Contracting States:
**DE FR GB IT NL**

(71) Applicant: **NATIONAL SEMICONDUCTOR CORPORATION**
**2900 Semiconductor Drive P.O. Box 58090**
**Santa Clara California 95051-8090(US)**

(72) Inventor: **Gould, Norman L.**
**1676 Santa Barbara Dr.**
**San Jose, CA 95125(US)**

(74) Representative: **Sparing - Röhl - Henseler**
**Patentanwälte**
**Rethelstrasse 123 Postfach 14 02 68**
**D-4000 Düsseldorf 1(DE)**

(54) **Outer lead bonding device.**

(57) An outer lead bonding device (10) has an insert housing (16) which is comprised of two clam shell parts (16a, 16b) made from Inconel and a bond tool insert (18) made from silicon carbide. A shaft (12) is attached to one of the clam shells (16b), the shaft (12) being inserted into a bonding machine (14). The bond tool insert (18) is encased by the clam shells (16a, 16b) which have recesses (44) for holding the insert (18). The insert (18) has two parallel bond tips (26) extending down from its planar base (19). A heating element (36), housed in the horizontal bores (22a, 22b, 22c), directly heats the bond tips (26), the insert (18) and the insert housing (16). A thermocoupler (38), housed in the thermocoupler bore (28) monitors the temperature of the insert housing (16), the bonding tips (26), and the insert (18). The insert (18) has a shoulder (20) and a flat section (32).

FIG. 1

The present invention broadly relates to a semiconductor bonding device. More particularly, the invention involves a bonding tool that applies a thermal compression bond to an outer lead frame to a semiconductor integrated circuit chip utilizing a directly heated bonding tip element.

In semiconductor integrated circuit (I/C) packaging, an outer lead frame is bonded to the I/C chip using thermal compression bonding and then the I/C is sealed in a plastic encapsulant. The outer leads are used to mount the I/C chip onto a circuit board.

In the past, when semiconductor chips were limited to small die sizes (i.e., up to 150 mils X 150 mils), outer lead bonding tools were available for adequately bonding the outer leads to the I/C. However, as the size, and hence, the length of the lead to the chip to be bonded increased, the deficiencies of the prior art bonding tools became prevalent. As illustrated in Figures 6 and 7, a conventional bonding tool consists of two parts: a bonding insert tool made out of one material, typically Inconel, and the bonding tips made out of a second material, typically a diamond dust compact.

As best illustrated in Figure 7, the bonding tips are formed by cutting a groove out of the diamond dust compact material attached to the base of the insert tool, the groove being such that the diamond dust compact tips fit over the lead frame and tape during the bonding process. The diamond dust compact bonding tips are sintered to the base of the Inconel insert tool. The bonding insert tool has a bore through it where a heater may be inserted. Since the heater is located in the insert tool, and not in direct contact with the bonding tips, the bonding tips are heated via heat transfer from the heater through the Inconel insert tool to the bonding tips.

As die sizes have increased, the larger the I/C chips to be bonded to the outer lead frame and the longer the bonding tips. Hence, the greater the surface area of the diamond dust compact material, and, in particular, the bonding tips, over which the heat has to dissipate, from the bonding insert tool through to the diamond dust compact bonding tips. For die sizes over 150 mils X 150 mils, the conventional bonding tips are unevenly heated due to an uneven heat transfer at the junction of the bonding insert tool down to the diamond dust compact bonding tips. Since the tips are not evenly heated, the outer lead frame is unevenly bonded to the tape from the I/C chip since the outer ends of the tips have not been heated enough to bond properly.

In addition to the uneven heat transfer problem between the directly heated insert tool and the indirectly heated bonding tips, the design of the prior art bonding tips also contributes to poor bonding. As stated above, conventional bond tips are made out of diamond dust compact which has a deflection coefficient so that when the tips are heated, they become convex, the outer ends of the tips curving downward.

Since the conventional tips become convex, and hence, are not planar, when thermal pressure is applied to bond the lead frame to the tape from the chip, the bonding that occurs is uneven: only the outside edges get bonded because the outside edges of the bond tips touch the lead frame first.

The convexity of the bond tips also results in bond tool instability. Since the shape of the bond tips changes, the bonding machine's settings continuously have to be readjusted.

The present invention is directed towards overcoming each of the deficiencies mentioned above and aspects of the present invention are defined respectively in claims, 1. 12, and 19.

The present invention provides a semiconductor integrated circuit outer lead bonding device for bonding a lead frame to a tape that is bonded to an integrated circuit chip. The bonding device has an insert housing made of Inconel, or a material having a similar thermal conductivity and coefficient of thermal expansion. The insert housing holds a bonding tool insert having integrally formed bonding tips extending down from its planar bottom surface. The bonding tips and bonding tool insert are made from silicon carbide or a material having similar a hardness, coefficient of thermal expansion, thermal conductivity, and deflection coefficient.

The insert housing of the preferred embodiment is made of two clam shell parts: the two part insert housing design makes it quicker and easier to change the insert during the packaging assembly process. The shaft, which is used to mount the outer lead bonding tool to the bonding machine, is located on one of the two clam shells; thus, one clam shell remains in the machine while the other clam shell is removed, and the insert is replaced.

The insert housing, the bonding tool insert, and hence, the bonding tips, are heated directly by a heating element housed in the insert and the insert housing. Therefore, there is no heat loss due to heat transfer between the two elements which are each made from a different material. The heating element is positioned in the insert and in the insert housing so that it is equidistant from the bonding tips. The bonding tips of the present invention achieve uniform bonding since silicon carbide, which has a deflection coefficient of 0, does not curve when it is heated. In addition, since the bonding tips are heated directly, the tips are uniformly heated to the proper bonding temperature.

It is therefore an object of the present invention to provide an outer lead bonding device that directly heats bonding tips that maintain their planarity, as the length of the bonding tips increases, and which employs thermal compression pressure to bond the outer lead frame to a tape from the I/C chip. The present invention also employs a practical design so that the bonding inserts can be changed during the packaging assembly process with minimal delay.

These, and further objects and advantages of the invention will be made clear during the course of the following description of the invention.

In the accompanying drawings:

Figure 1 is a perspective view of the outer lead bonding device during use in the integrated circuit packaging assembly.

Figure 2 is a front elevational view of the outer lead bonding device.

Figure 3 is a cross sectional elevational view of the bonding device along the 3 - 3 line of Figure 2.

Figure 4 is a bottom plan view of the bonding device along the 4 - 4 line of Figure 3.

Figure 5 is an exploded perspective view of the outer lead bonding device viewing it from the bottom.

Figure 6 is a front elevational view of the prior art outer lead bonding device, illustrating that the bond tips are formed by creating a groove in the diamond dust compact material which attaches at the base of the insert tool.

Figure 7 is a cross sectional elevational view of the prior art outer lead bonding device of Figure 6 depicting the heating element in the insert tool.

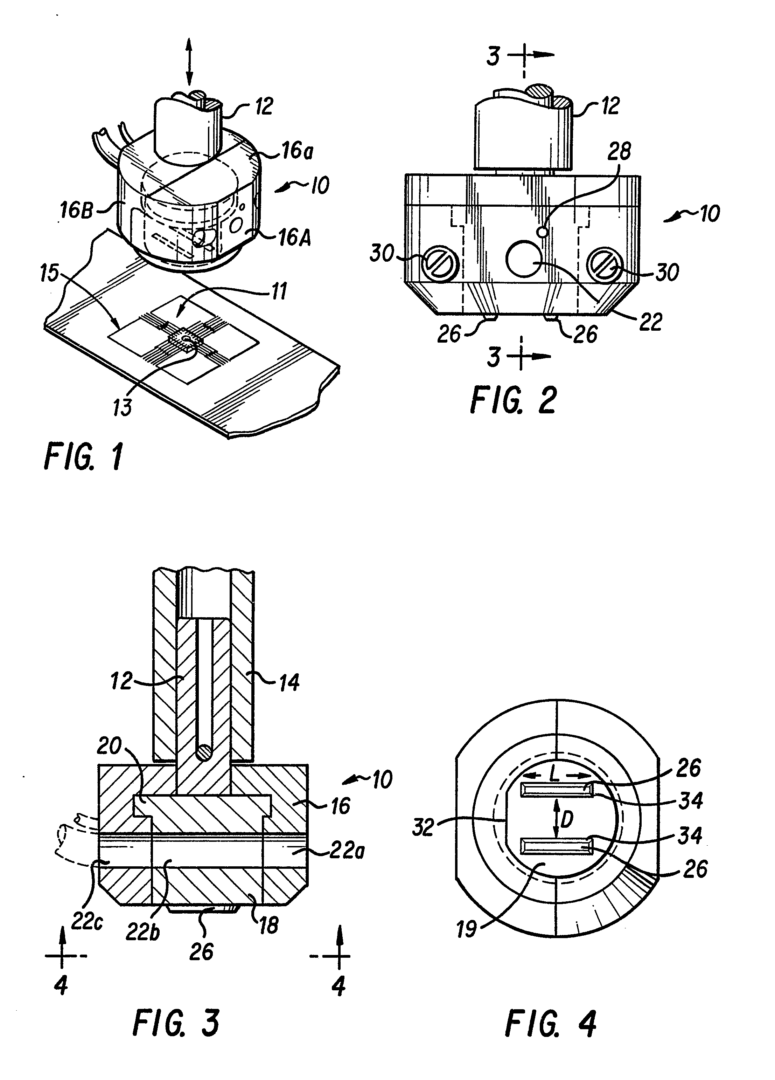

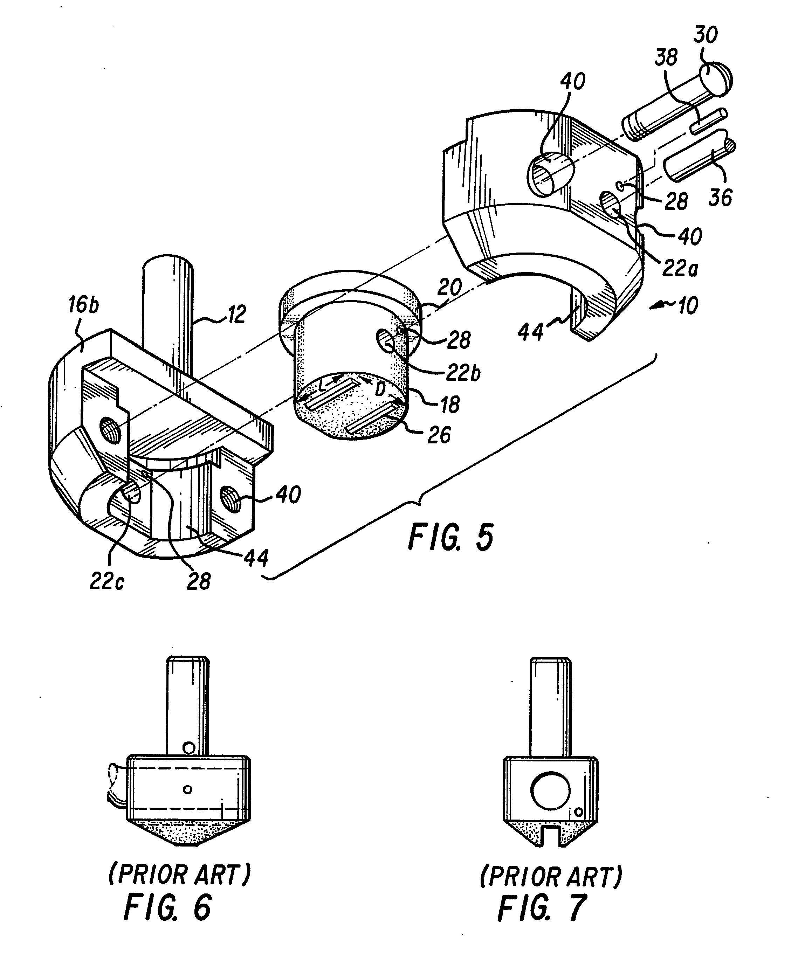

Referring to Figures 1 and 3, a semiconductor integrated circuit outer lead bonding device 10 is depicted. The bonding device 10 bonds outer leads 11 on a lead frame 15 to a tape that is bonded to an I/C chip 13 during the packaging assembly process. The device 10 has a shaft 12 that is inserted into a bonding machine 14 such as the Shinkawa bonding machine model OL1. The shaft 12 is positioned on one of the two clam shells 16a, 16b. The two clam shells 16a, 16b together form an insert housing 16. Referring also to Figures 2 and 5, the clam shells 16a, 16b are designed to attach together and hold the bonding tool insert 18 into the bonding machine 14. The two clam shells 16a, 16b are secured together by two screws 30 inserted into the screw holes 40. By designing the insert housing 16 to be comprised of two parts 16a, 16b, it is easier to change the bond tool insert 18 to accommodate bonding different integrated circuit die sizes during the packaging assembly process.

The shaft 12 is located on one of the two clam shells 16b so that the shaft 12 and one of the clam shells 16b remain in the machine while the insert 18 is changed. To change the insert 18, the screws 30 are removed, the other clam shell 16a is removed, the old insert 18 is replaced with a new insert, and the clam shells 16a, 16b are screwed back together. By leaving the shaft 12 and one of the clam shells 16b in the machine 14, the delay associated with reconfiguring the bonding device 10, during the packaging assembly process, is reduced.

The clam shells 16a, 16b and the shaft 12 are made of Inconel in the preferred embodiment, but may be made of a material having similar material characteristics: a coefficient of thermal expansion ranging from about 11.0 to 13.0, a hardness factor ranging from about 82 to 100 knoops, and a thermal conductivity heat transfer of about 8.6 BTU/ft-hr-degree F.

Reference is now made to Figures 3 and 5. When the clam shells 16a, 16b are screwed together, they define a recess 44 that corresponds to the shape of the insert 18 that it is to hold. When the clam shells 16a, 16b hold the insert 18, the three pieces 16a, 16b, 18 mate together. Horizontal bores 22a, 22b, 22c through the clam shells 16a, 16b and the insert 18 are respectively aligned with one another, and are designed for receiving the heating element 36. The heating element 36 is positioned in the insert 18 and the clam shells 16a, 16b so that it is equidistance from each of the bond tips 26 so that the heat transfer path is the same length to all parts of the tips 26.

The bonding tool insert 18 is substantially round with an upper shoulder 20 that extends out past the edge of the main body of the insert 18. The insert 18 is made of silicon carbide, a material that has similar properties to that of diamond, while being substantially less expensive. The insert 18, however, may also be made from a material having similar physical properties as silicon carbide: a coefficient of thermal expansion ranging from about 2.1 to 3.0, a hardness factor of 2900 to 3000 knoops, a thermal conductivity heat transfer of about 86.5 BTU/ft-hr-degree F, and a deflection coefficient of about 0.

The shoulder 20 prevents the insert from falling out of the housing 16 when the insert 18 and the insert housing 16 are heated. Since Inconel has a coefficient of expansion of approximately 11, and silicon carbide has a coefficient of expansion of approximately 3, the Inconel housing 16 will expand at a quicker rate than the silicon carbide insert 18 and leave a gap of about 0.001 to 0.003 mils between the insert 18 and the insert housing 16. Hence, the shoulder 20 extends out a sufficient amount to prevent the insert 18 from falling out from between the clam shells 16a, 16b during the heating process. In addition, to keep the insert 18 from falling, the screws 30 may be tightened and pressure exerted on the upper part of the clam shells 16a, 16b. The insert 18 also has a flat portion 32 to prevent it from rotating while it is mounted in the insert housing 16.

Referring to Figure 4, the bottom surface 19 of the insert 18 is substantially planar except for having two parallel straight bonding tips 26 protruding downward. The surface of the tips 26 is also planar. The tips 26 are spaced a predetermined distance, D, apart on the insert 18. The distance, D, is determined based upon the dimensions of the rectangular I/C chip 13. Specifically, the distance, D, is the distance between the first set of two parallel sides of the chip 13 to be bonded such that bonding occurs at the borders of the I/C chip 13. The length, L, of the tips 26 is also predetermined based upon the length of the first set of parallel sides of the chip 13 to be bonded since the bonding occurs across the length of the borders of the chip 13. Each of the tips 26 is surrounded by a chamfer 34.

The bonding tool insert 18 and the bonding tips 26 are heated directly since the heater element 36 is housed inside the bore 22b in insert 18. By heating the tips 26 directly, the heat loss associated with heat transfer at the junction of two different materials is avoided. Since the tips 26 are heated directly, the tips 26 are heated substantially uniformly; by uniformly heating the tips 26, the lead frame 15 will properly bond to the tape from the I/C chip 13.

By applying thermal pressure to the bonding tips 26, the tips 26 contact the outer lead frame 15 and the tape from the I/C chip 13 and bond the outer lead frame 15 to the chip 13. Since the bonding tips 26 are made of silicon carbide, which has a deflection coefficient of 0, when the tips 26 are heated, the tips 26 remain substantially planar; they do not become convex as is the case with conventional bonding tools.

The insert housing 16 is also directly heated by the heating element 36 since the heating element 36 is also housed in bores 22a, 22c located in the clam shells 16a, 16b. The temperature of the bonding tips 26 is monitored by a thermocoupler 38. The thermocoupler 38 is placed in the thermocoupler bores 28a, 28b, 28c located in the insert 18 and in the clam shells 16a, 16b. The thermocoupler bores 28a, 28b, 28c are respectively aligned with one another so that the thermocoupler 38 can extend through the insert 18 and the clam shells 16a, 16b concurrently. The bonding temperature ranges from about 400 to 600°C, and is preferably about 550°C.

Since the bonding tips 26 remain planar after being heated, the device 10 configuration does not change significantly and the bonding device 10 remains substantially stable throughout the bonding process. During the packaging assembly process, two bonding devices 10 are used. The first bonding device 10 has its bonding tips 26 positioned in one direction to bond two of the four sides of the chip 13, with the length, L, and distance, D, between the tips 26 predetermined based upon the configuration of the first two parallel sides of the chip 13 to be bonded.

After bonding the first two sides of the rectangular chip 13, the other two sides are bonded by a second bonding device 10. The second bonding device 10 has its bonding tips 26 positioned 90 degrees from the position of the first device. The bonding tips 26 of the second bonding device 10 have a length, L, and distance, D, between them predetermined based upon the configuration of the second set of parallel sides to be bonded.

Having thus described the invention, it is recognized that those skilled in the art may make various modifications or additions to the preferred embodiment chosen to illustrate the invention without departing from the spirit and scope of the present contribution to the art. Accordingly, it is to be understood that the protection sought and to be afforded hereby should be deemed to extend to the subject matter claimed and all equivalents thereof within the scope of the invention.

## Claims

1. A bonding device comprising:
bonding means for bonding at least two surfaces, the bonding means having at least one bond tip;
a heating element mounted in the bonding means for heating the bonding means so that there is direct heat transfer between the heating element and the bond tip.

2. The device of claim 1, wherein the bonding means comprises a first material having a coefficient of thermal expansion of about 2.1-3.0, a hardness factor of about 2900-3000 knoops, a thermal conductivity of about 86.5 BTU/ft-hr-degree F and a deflection coefficient of about 0.

3. The device of claim 2, wherein the first material is silicon carbide.

4. The device of claim 1, further comprising housing means for housing the bonding means during bonding.

5. The device of claim 4, wherein the housing means comprises a second material having a coefficient of thermal expansion of about 11-13 and a thermal conductivity of about 8.6 BTU/ft-hr-degree F.

6. The device of claim 5, wherein the second material is Inconel.

7. The device of claim 1, wherein the bonding means has a bottom surface having the bond tip projecting downward therefrom for contacting at least one of the surfaces to be bonded, the bonding means having a first bore therethrough for housing the heating element.

8. The device of claim 4, wherein the housing means has a second bore therethrough for housing at least a portion of the heating element.

9. The device of claim 1, having two bond tips formed therein in parallel spaced-apart relation, the length of each bond tip and the distance between each bond tip being preselected.

10. The device of claim 9, wherein the heating element is equidistant from each of the bond tips.

11. The device of claim 1, wherein the bond tip remains substantially planar during heating.

12. A bonding device of the type utilizable for applying a thermal compressive force to the outer leads of a lead frame for bonding the lead frame to an integrated circuit chip, the bonding device comprising:
a bonding element having at least one bond tip projecting therefrom for contacting a surface to be bonded;
a housing securable to a bonding machine for holding the bonding element; and
a heating element mounted in contact with the bonding element for directly heating the bonding element.

13. The device of claim 12, wherein:
the bonding element comprises a first material having a coefficient of thermal expansion of about 2.1- 3.0, a hardness factor of about 2900-3000 knoops, a thermal conductivity of about 86.5 BTU/ft-hr-degree F, and a deflection coefficient of about 0; and
the housing comprising a second material having a coefficient of thermal expansion of about 11-13 and a thermal conductivity of about 8.6 BTU/ft-hr-degree F.

14. The device in claim 13, wherein the first material is silicon carbide.

15. The device in claim 13, wherein the second material is Inconel.

16. The device of claim 12, wherein the bonding element has a first bore therethrough and the housing has a second bore therethrough, the first and second bores being substantially the same size and aligned with each other for receiving the heating element.

17. The device of claim 12, having two bond tips formed therein in parallel, spaced-apart relation wherein the heating element is equidistant from the bond tips.

18. The device of claim 12 wherein the bond tip remains substantially planar during heating.

19. A bonding device, comprising:
a bonding means having a bottom surface, the bottom surface having at least one bond tip projecting therefrom for contacting a surface to be bonded, the bond tip being substantially planar, the bonding means having a first bore therethrough and comprising a first material having a coefficient of thermal expansion of about 2.1-3.0, a hardness factor of about 2900-3000 knoops, a thermal conductivity of about 86.5 BTU/ft-hr-degree F, and a deflection coefficient of about 0;
a housing for housing the bonding means, the housing comprising a second material having a coefficient of thermal expansion of about 11-13, and a thermal conductivity of about 8.6 BTU/ft-hr-degree F, and having a second bore therethrough; and
a heating element for heating the bonding means directly, the first and second bores being substantially the same size and respectively aligned such that the heating element is slidably housed within the first and second bores for heating the bonding means and housing directly.

20. The device of claim 19, wherein the housing comprises a shell having a first part and a second part, the first part having a first groove and the second part having a second groove for removably housing the bonding means between the first and second parts.

21. The device of claim 20, further comprising means for detachably joining the first part and the second part of the shell.

22. The device of claim 19, wherein the bonding means has a first horizontal bore therethrough and the housing means has a second horizontal bore therethrough.

23. The device in claim 19 further comprising:
means for regulating the temperature of the bond tip.

24. The device in claim 19, wherein the first material is silicon carbide.

25. The device in claim 19, wherein the second material is Inconel.

26. The device in claim 19, wherein the bond tip remains substantially planar during heating.

FIG. 1

FIG. 2

FIG. 3

FIG. 4

**FIG. 5**

(PRIOR ART)
**FIG. 6**

(PRIOR ART)
**FIG. 7**